(19) Europäisches Patentamt
European Patent Office
Office européen des brevets

(11) EP 3 350 655 B1

(12) **FASCICULE DE BREVET EUROPEEN**

(45) Date de publication et mention de la délivrance du brevet:
**26.06.2019 Bulletin 2019/26**

(21) Numéro de dépôt: **16784799.5**

(22) Date de dépôt: **14.09.2016**

(51) Int Cl.:
***G03F 7/32*** *(2006.01)*

(86) Numéro de dépôt international:
**PCT/EP2016/071695**

(87) Numéro de publication internationale:
**WO 2017/046163 (23.03.2017 Gazette 2017/12)**

(54) **SOLVANTS DE DÉCAPAGE DES RÉSINES PHOTOSENSIBLES**

LÖSUNGSMITTEL ZUM ENTFERNEN VON FOTOLACKEN

SOLVENTS FOR REMOVING PHOTORESISTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.09.2015 FR 1558739**

(43) Date de publication de la demande:
**25.07.2018 Bulletin 2018/30**

(73) Titulaire: **Rhodia Operations**
**75009 Paris (FR)**

(72) Inventeur: **BOURDETTE, Arnaud**
**77500 Chelles (FR)**

(74) Mandataire: **Cordier, Pascal Christian**
**Rhodia Operations**
**Direction de la Propriété Industrielle**
**40, rue de la Haie Coq**
**93306 Aubervilliers (FR)**

(56) Documents cités:
**EP-A2- 0 143 303**
**WO-A1-2011/154661**
**WO-A1-2014/096071**
**CN-A- 104 870 523**
**JP-A- 2005 045 070**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 350 655 B1

## Description

La présente invention a trait au domaine du décapage des résines photosensibles employées dans les procédés de photolithographie.

Les résines photosensibles (également désignées sous le terme de « photorésine » ou « *photoresist* ») sont des matériaux bien connus, dont les propriétés diffèrent avant et après exposition à une irradiation adéquate. Cette irradiation est typiquement une radiation éléctromagnétique, par exemple un rayonnement UV de longueur d'onde entre 300 et 450 nm pour les photorésines de type DNQ (diazonaphthoquinone), ou ou bien, plus rarement, un faisceau d'électrons pour des résines plus spécifiques (au sens large, les résines de ce type seront considérées ici comme « photosensibles », même si elle n'implique pas un rayonnement lumineux).

Typiquement, l'irradiation modifie la solubilité de la résine photosensible dans un solvant dit « révélateur ». Il existe dans ce cadre deux types de résines photosensibles, à savoir :

- les résines photosensibles, dites « positives » :
  avant exposition, ces résines sont insolubles (ou bien très lentement solubles) dans le solvant révélateur. A l'inverse, après l'exposition, elles deviennent solubles (ou au moins beaucoup plus rapidement soluble, avec typiquement une vitesse de dissolution du film multipliée au moins par un facteur 100); et

- les résines photosensibles, dites « négatives » :
  avant exposition, ces résines sont solubles dans le solvant révélateur, et, après l'irradiation, elles deviennent insolubles (ou au moins solubles beaucoup plus lentement, avec typiquement une vitesse de dissolution du film réduite au moins par un facteur 100).

Les résines photosensibles permettent notamment de former des revêtements ajourés sur la surface d'un substrat, ce qui est utilisé dans de nombreux procédés industriels, incluant notamment la photolithographie qui permet la préparation des composants micro-électroniques (puces, diodes, transistors, écrans...).

Selon une méthode connue en soi, une résine photosensible employée en photolithographie est typiquement déposée sous forme d'un film fin sur la surface d'un substrat (du silicium ou de l'oxyde de silicium par exemple) puis elle est exposée, sur certaines zones seulement à la radiation induisant sa modification de solubilité. L'irradiation sélective modifie alors la résine seulement là où elle a été exposée, formant ainsi deux type de zone sur la surface, à savoir des zones dites « solubles », éliminables par le solvant révélateur et des zones dites « insolubles », qui ne sont pas -ou bien plus difficilement- éliminables par le solvant révélateur. Par action du solvant révélateur, on élimine alors les zones solubles selon une étape qui sera désignée dans a présente description sous le terme de « décapage de la résine photosensible ».

Avec une résine photosensible positive, l'étape dite de décapage de la résine photosensible par le solvant révélateur permet en fait d'éliminer la résine qui a été photosensibilisée (irradiée).

Dans le cas d'une une résine photosensible négative, l'étape de décapage de la résine photosensible permet au contraire d'éliminer la résine qui n'a pas été photosensibilisée (irradiée).

Le décapage de la résine photosensible laisse subsister un film déposé sur la surface selon un motif qui masque uniquement les zones non irradiées dans le cas d'une résine positive et qui ne ne masque que les zones irradiées dans le cas d'une résine négative. (En pratique, on irradie la surface à traiter au travers d'un masque ajouré. L'emploi de résine positive permet, après irradiation et action du solvant de reproduire sur la surface un film de résine protectrice qui est l'image exacte du masque. La résine négative, au contraire, forme sur la surface l'image du masque en négatif). Ce masquage sélectif permet une protection sélective de la surface, ce qui permet typiquement de graver les zones non protégées en laissant intactes celles situées sous le film.

La présente invention s'intéresse à un nouveau type de solvant révélateur adapté pour effectuer un décapage de résine photosensible du type précité.

A l'heure actuelle, le décapage de résine photosensible est le plus souvent réalisé au moyen de N-méthyl pyrrolidone (1-methyl-2-pyrrolidone, ci-après désignée par « NMP »).

La NMP est connue comme efficace pour effectuer le décapage de nombreuses résines photosensibles usuellement employées en photolithographie. La NMP est en outre un solvant puissant qui permet de garder la résine dissoute en solution et l'élimination des impuretés organiques.

Toutefois, un problème avec la NMP réside dans sa toxicité. En Europe, par exemple, ce solvant est dans la liste dite SVHC (pour l'anglais «*Substances of Very High Concern*») de l'Agence Européenen des Produits Chimiques (ECHA) et classifiée comme agent chimique dangereux CMR 1B, et correspondant à une substance toxique pour la reproduction.

Un but de la présente invention est de fournir un moyen efficace de réaliser un décapage de résine photosensible qui ne présente pas les problèmes de toxicité de la NMP. En d'autres termes, l'invention vise à fournir un révélateur

alternatif non toxique à la NMP qui permettent de décaper la plupart, sinon la totalité, des résines photosensibles utilisables avec la NMP.

A cet effet, la présente invention propose d'effectuer le décapage au moyen d'un mélange de solvants spécifique, dont les inventeurs ont maintenant mis en évidence qu'il assure un décapage efficace des résines photosensibles, en particulier la plupart des résines photosensibles que la NMP permet de décaper.

Plus précisément, selon un premier aspect, la présente invention a pour objet l'utilisation, pour le décapage d'une résine photosensible, d'un mélange de solvants comprenant au moins deux, voire trois, des solvants (S1), (S2) et (S3) ci-après :

**(S1)** un solvant comprenant au moins un composé esteramide répondant à formule (I) suivante :

$$R^1OOC\text{-}A\text{-}CONR^2R^3 \qquad (I)$$

où:

$R^1$ est un groupe choisi parmi les groupes hydrocarbonés comprenant un nombre moyen d'atomes de carbone allant de 1 à 36, saturés ou insaturés, linéaires ou ramifiés, éventuellement cycliques, éventuellement aromatiques,

$R^2$ et $R^3$, identiques ou différents, sont des groupes choisis parmi les groupes hydrocarbonés comprenant un nombre moyen d'atome de carbone allant de 1 à 36, saturés ou insaturés, linéaires ou ramifiés, éventuellement cycliques, éventuellement aromatiques, éventuellement substitués, $R^2$ et $R^3$ pouvant éventuellement former ensemble un cycle, éventuellement substitué et/ou comprenant éventuellement un hétéroatome, et

A est un groupe alkyle divalent linéaire ou ramifié comprenant un nombre moyen d'atomes de carbone allant de 2 à 12, de préférence de 2 à 4.

**(S2)** le diméthylsulfoxyde DMSO

**(S3)** la cyclopentanone $C_5H_8O$

La notion de « nombre moyen » d'atome de carbone, au sens où elle est employée ici s'entend dans son acception la plus usuelle. Ainsi, pour un solvant (S1) contenant un seul et unique composé de formule (I), le « nombre moyen » d'atomes de carbone dans les groupement $R^1$, $R^2$, $R^3$ et A est strictement égal au nombre de carbone dans chacun de ces groupes. Dans certains cas de figure, le solvant (S1) peut contenir plusieurs composé de formule (I) qui peuvent se distinguer par leurs groupes $R^1$ et/ou $R^2$ et/ou $R^3$ et/ou A. Dans ce cas, le nombre moyen d'atome de carbone dans chaque groupe est typiquement défini par la moyenne en nombre notée N du nombre d'atomes de carbone dans un groupement donné dans la population totale de composés de formule (I). A titre d'exemple, le nombre moyen d'atomes de carbone $N(R^1)$ dans le groupement $R^1$ pour une population de composés de formule (I) qui présentent des groupements $R^1$ distincts peut être calculé comme suit :

$$N(R^1) = \sum_{i=I\,min}^{Imax} iNi \,/\, \sum_{i=I\,min}^{Imax} Ni$$

où :

- Imin et Imax sont deux nombres entiers, égaux respectivement au nombre minimal et aunombre maximal d'atomes de carbone dans les groupements $R^1$ des composés de la population considérée ; et
- pour chaque valeur de i allant de Imin à Imax, Ni rest un nombre entier égal au nombre de composés de la population où le groupe $R^1$ comporte exactement i atomes de carbone.

Selon un autre aspect, l'invention a pour objet un procédé de dépôt sélectif d'un revêtement sur certaines zones seulement de la surface d'un substrat, comprenant (a) un dépôt sur ladite surface d'un film de résine photosensible ; puis (b) une irradiation sélective dudit film sur certaines zones uniquement ; puis (c) le décapage dudit film par un solvant de décapage, où ledit solvant de décapage est un solvant du type précité.

Le procédé de l'invention peut notamment être employé en photolithographie, notamment pour la fabrication

d'un circuit imprimé, d'un composant micro-électronique ou d'un écran.

Les travaux effectués dans le cadre de la présente invention ont maintenant permis de montrer que les mélanges du type précité permettent un décapage acceptable, et dans certains cas très efficace, des résines photosensibles, et notamment celles classiquement décapées par la NMP.

En outre, les mélanges de solvant selon l'invention présentent l'intérêt d'être hydrosolubles, ce qui permet un rinçage simple et efficace après le décapage, par simple lavage à l'eau.

Selon un premier mode possible de réalisation de la présente invention, le mélange de solvants employé comprend (voire et constitué par) le solvant (S1) et le solvant (S2).

Dans ce mode de réalisation, le rapport massique S1/S2 de la masse du solvant (S1) rapportée à la masse du solvant (S2) est de préférence comprise entre 0,1 et 10. Par exemple, on pourra employer selon ce mode des mélange comprenant les solvants (S1) et (S2) dans les proportions massiques respectives suivantes : 10:90 ; 20:80 ; 30:70 ; 40:60 ; 50:50 ; 60:40 ; 70:30 ; 80:20 ou 90:10.

Au sens de la présente description, « un mélange comprenant les solvants (S1) et (S2) dans les proportions massiques respectives 10:90 » désigne un mélange de solvants incluant, entre autres solvants possibles, les solvants (S1) et (S2), et où le rapport de la masse du solvant (S1) sur le total des masse des solvants (S1) et (S2) est de 10% (le rapport de la masse du solvant (S2) sur le total des masse des solvants (S1) et (S2) étant lui de 90%).

Selon ce premier mode de réalisation, le rapport massique (S1)/(S2) est de préférence le plus élevé possible, par exemple supérieur ou égal à 1. En effet, le DMSO a une odeur particulière assez désagréable et on préfère souvent en diminuer la teneur. Notamment pour cette raison, on pourra préférer employer les mélanges comprenant les solvants (S1) et (S2) dans les proportions massiques respectives suivantes: 50:50; 60:40 ; 70:30 ; 80:20 ou 90:10.

Les inventeurs ont cependant observé que les mélanges selon ce premier mode tendent à présenter une meilleure efficacité de décapage lorsque la teneur en DMSO augmente. Dans cette optique, s'avèrent avantageux des mélanges où le rapport (S1)/(S2) est plus faible, par exemple inférieur ou égal à 1. Notamment pour cette raison, on pourra donc préférer employer les mélanges comprenant les solvants (S1) et (S2) dans les proportions massiques respectives suivantes : 10:90 ; 20:80 ; 30:70 ; 40:60 ; 50:50.

Selon une première variante possible de ce premier mode de réalisation, le mélange de solvants utilisé selon l'invention est constitué uniquement des solvants (S1) et (S2), avantageusement dans les proportions précitées.

A titre d'exemple, un mélange de solvants intéressant selon l'invention est constitué par les solvants (S1) et (S2) dans des proportions massiques comprises entre 40 :60 et 60 :40, notamment dans les proportions massiques 50:50.

Un autre exemple de mélange de solvants intéressant selon l'invention est constitué par les solvants (S1) et (S2) dans des proportions massiques comprises entre 20 :80 et 40 :60, notamment dans les proportions massiques 30:70.

Encore un autre exemple de mélange de solvants intéressant selon l'invention est constitué par les solvants (S1) et (S2) dans des proportions massiques comprises entre 5 :85 et 20:80, notamment dans les proportions massiques 10:90.

Selon une seconde variante possible du premier mode de réalisation, le mélange de solvants utilisé selon l'invention peut comprendre un ou plusieurs autres solvants en plus des solvants (S1) et (S2), et notamment le solvant (S3).

Selon une variante particulière, le mélange de solvants selon l'invention comprend les solvants (S1), (S2) et (S3). Le mélange de solvants selon l'invention peut typiquement être constitué uniquement des solvants (S1), (S2) et (S3).

Lorsque le mélange de solvants selon l'invention comporte les solvants (S1), (S2) et (S3), le rapport massique S3/(S1+S2) de la masse du solvant (S3) sur le total des masses des autres solvants est de préférence inférieur à 50%, le plus souvent inférieur à 25%, voire à 15%. La présence du solvant S3 induit en général une diminution du point éclair du solvant et il peut donc être avantageux d'en réduire la teneur lorsqu'on cherche à obtenir un point éclair élevé.

Le plus souvent, que les solvants S1 et S2 soient présents conjointement ou non, il est préférable dans un mélange selon l'invention que le rapport massique S3/(S1+S2) soit inférieur à 10%, par exemple entre 2 et 7%, typiquement de l'ordre de 5%.

A titre d'exemple, un mélange de solvants intéressant selon l'invention est constitué par les solvants (S1), (S2) et (S2) dans les proportions massiques 35:60:5.

Un autre exemple typique de mélange de solvants intéressant selon l'invention est constitué par les solvants (S1) et (S2) dans les proportions massiques 30:65:5.

Un autre exemple typique de mélange de solvants intéressant selon l'invention est constitué par les solvants (S1) et (S2) dans les proportions massiques 25:70:5.

Encore un autre exemple de mélange de solvants intéressant selon l'invention est constitué par les solvants (S1) et (S2) dans les proportions massiques 20:75:5.

Encore un autre exemple de mélange de solvants intéressant selon l'invention est constitué par les solvants (S1) et (S2) dans les proportions massiques 15:80:5.

Encore un autre exemple de mélange de solvants intéressant selon l'invention est constitué par les solvants (S1) et (S2) dans les proportions massiques 10:85:5.

Encore un autre exemple de mélange de solvants intéressant selon l'invention est constitué par les solvants (S1) et (S2) dans les proportions massiques: 5:90:5.

Selon un deuxième mode possible de réalisation de la présente invention, le mélange de solvants employé comprend (voire et constitué par) le solvant (S1) et le solvant (S3).

Dans ce mode de réalisation, le rapport massique S1/S3 de la masse du solvant (S1) rapportée à la masse du solvant (S3) est de préférence comprise entre 0,1 et 100, et il est typiquement entre 1 et 20. Par exemple, on pourra employer selon ce mode des mélange comprenant les solvants (S1) et (S3) dans les proportions massiques respectives suivantes : 50:50 ; 60:40 ; 70:30 ; 75:25 ; 80:20 ; 85:15 ; 90:10 ; ou 95:5. Lorsqu'on cherche à obtenir un point éclair élevé, il est en général adapté de limiter la quantité de solvant (S3). En effet, plus sa teneur augmente, et plus le point éclair du mélange tend à diminuer. A cet effet, on pourra employer des mélanges comprenant les solvants (S1) et (S3) dans des proportions massiques avantageusement comprises entre 70:30 et 95:5.

Selon une variante possible de ce premier mode de réalisation, le mélange de solvants utilisé selon l'invention est constitué uniquement des solvants (S1) et (S3), avantageusement dans les proportions précitées. A titre d'exemple, un mélange de solvants intéressant selon l'invention est constitué par les solvants (S1) et (S3) dans des proportions massiques comprises entre 80:20 et 95 :5, notamment dans les proportions massiques comprises entre 85:15 et 95:5, par exemple.

Selon un troisième mode possible de réalisation de la présente invention, le mélange de solvants employé comprend (voire et constitué par) le solvant (S2) et le solvant (S3).

Dans ce mode de réalisation, le rapport massique S2/S3 de la masse du solvant (S2) rapportée à la masse du solvant (S3) est de préférence comprise entre 0,1 et 100, typiquement entre 1 et 20. Par exemple, on pourra employer selon ce mode des mélange comprenant les solvants (S1) et (S2) dans les proportions massiques respectives suivantes : 50:50 ; 60:40 ; 70:30 ; 75:25 ; 80:20 ; 85:15 ; 90:10 ; ou 95:5.

Le rapport (S2)/(S3) est de préférence le plus faible possible, si on souhaite diminuer l'odeur liée à la présence de DMSO. Notamment pour cette raison, on pourra préférer employer les mélanges comprenant les solvants (S1) et (S2) dans les proportions massiques respectives suivantes : 30:70 ; 40 :60 ; 50:50 ; 60:40 ; ou 70:30.

En termes de point éclair, s'avèrent cependant souvent plus avantageux des mélanges où le rapport (S2)/(S3) est plus élevé. De plus Notamment pour ces raisons, on pourra donc préférer employer les mélanges comprenant les solvants (S2) et (S3) dans les proportions massiques respectives suivantes : 75:25 ; 80:20 ; 85:15 ; 90:10 ; ou 95:5

Selon une variante possible de ce premier mode de réalisation, le mélange de solvants utilisé selon l'invention est constitué uniquement des solvants (S2) et (S3), avantageusement dans les proportions précitées.

A titre d'exemple, un mélange de solvants intéressant selon l'invention est constitué par les solvants (S2) et (S3) dans des proportions massiques comprises entre 80:20 et 95 :5, notamment dans les proportions massiques comprises entre 85:15 et 95:5

Différentes caractéristiques et modes de réalisation préférentiels de l'invention sont décrits en détails ci-après :

***Le solvant (S1)***

Le solvant de type (S1) utile dans le cadre de la présente invention, et notamment pour les premier et deuxième modes de réalisation précités, comprend de préférence un mélange de composés de formule (I) tels que définie ci-dessus où A, $R^1$, $R^2$ et $R^3$ ont les significations précitées. Ainsi, il peut avantageusement s'agir du solvant commercial Rhodiasolv® Polarclean disponible auprès de la société Solvay, qui comprend un tel mélange.

Dans les composés de formule (I) utiles selon l'invention, les groupes $R^1$, $R^2$ et $R^3$, qui sont identiques ou différents, peuvent notamment être des groupes choisis parmi les groupes alkyle, aryle, alkaryle, arylalkyle, typiquement en $C_1$-$C_{12}$, ou le groupe phényle. Les groupes $R^2$ et $R^3$ peuvent éventuellement être substitués, notamment par des groupes hydroxyle.

Le groupe $R^1$ peut notamment être choisi parmi les groupes méthyle, éthyle, propyle, isopropyle, n-butyle, isobutyle, n-pentyl, isopentyle, isoamyle, n-hexyle, cyclohexyle, 2-éthylbutyle, n-octyle, isooctyle, 2-ethylhexyle, tridecyle.

Les groupes $R^2$ et $R^3$, identiques ou différents, peuvent notamment être choisis parmi les groupes méthyle, éthyle, propyle (n-propyl), isopropyle, n-butyle, isobutyle, n-pentyle, amyle, isoamyle, hexyle, cyclohexyle, hydroxyéthyle. Les groupes $R^2$ et $R^3$ peuvent également être tels qu'ils forment ensemble avec l'atome d'azote un groupe morpholine, piperazine ou piperidine. Selon des modes particuliers de réalisation, $R^2$=$R^3$= méthyle, ou $R^2$=$R^3$= éthyle, ou $R^2$=$R^3$= hydroxyéthyle.

Selon un mode de réalisation particulier, si A comprend un groupe de formule $-CH_2-CH_2-$ et/ou de formule $-CH_2-CH_2-CH_2-CH_2-$ et/ou de formule $-(CH_2)_8-$ linéaire alors il s'agit d'un mélange de groupes A. Selon un mode de réalisation particulier, si A est linéaire, alors il s'agit d'un mélange de groupes A, par exemple d'un mélange de deux ou trois des groupes $-CH_2-CH_2-$ (éthylène); $-CH_2-CH_2-CH_2-$ (n-propylène); et $-CH_2-CH_2-CH_2-CH_2-$ (n-butylène).

Selon un mode de réalisation particulier, le groupe A est un groupe alkyle linéaire divalent choisi parmi les groupes de formules suivantes: $-CH_2-CH_2-$ (éthylène); $-CH_2-CH_2-CH_2-$ (n-propylène); $-CH_2-CH_2-CH_2-CH_2-$ (n-butylène), et leurs mélanges.

Selon une variante particulière dans ce premier mode de réalisation, le composé (I) utile selon l'invention est choisi parmi les composés suivants (où Me représente un groupe méthyle):

- $MeOOC-CH_2-CH_2-CONMe_2$
- $MeOOC-CH_2-CH_2-CH_2-CONMe_2$
- $MeOOC-CH_2-CH_2-CH_2-CONMe_2$, en mélange avec

$MeOOC-CH_2-CH_2-CH_2-CH_2-CONMe_2$ et/ou avec $MeOOC-CH_2-CH_2-CONMe_2$.

Selon un deuxième mode de réalisation particulier de l'invention, le groupe A est un groupe alkylène ramifié divalent de l'une des formules (IIa), (IIb), (IIc), (IIIa), et (IIIb) suivantes, ou un mélange d'au moins deux groupes choisis parmi les groupes de formules (IIa), (IIb), et (IIc) ou parmi les groupes de formules (IIIa) et (IIIb), ou un mélange d'au moins deux groupes choisis pour l'un parmi les groupes de formules (IIa), (IIb), et (IIc) et pour l'autres parmi les groupes de formules (IIIa) et (IIIb):

$$-(CHR^7)_y-(CHR^6)_x(CHR^7)_zCH_2-CH_2- \quad (IIa)$$

$$-CH_2-CH_2-(CHR^7)_z-(CHR^6)_x-(CHR^7)_y- \quad (IIb)$$

$$-(CHR^7)_z-CH_2-(CHR^6)_xCH_2-(CHR^7)_y- \quad (IIc)$$

$$-(CHR^7)_y-(CHR^6)_x-(CHR^7)_z-CH_2- \quad (IIIa)$$

$$-CH_2-(CHR^7)_z-(CHR^6)_x-(CHR^7)_y- \quad (IIIb)$$

où:

- x est un nombre entier supérieur à 0,
- y est un nombre entier moyen supérieur ou égal à 0,
- z est un nombre entier moyen supérieur ou égal à 0,
- $R^6$, identique ou différent, est un groupe alkyle en $C_1-C_6$ de préférence en $C_1-C_4$, et
- $R^7$, identique ou différent, est un atome d'hydrogène ou un groupe alkyle en $C_1-C_6$ de préférence en $C_1-C_4$.

Dans ce deuxième mode particulier le groupe A est de préférence un groupe tel que
$y = z = 0$.

De préférence, dans la formule (IIa) et/ou dans la formule (IIb):

- $x= 1$; $y = z = 0$; $R^6$ = méthyle.

De préférence, dans la formule (IIIa) et/ou dans la formule (IIIb):

- $x= 1$; $y = z = 0$; $R^6$ = éthyle.

Selon une variante particulière dans du deuxième mode de réalisation particulier, le composé de formule (I) utile selon l'invention est choisi parmi les composés suivants, et leurs mélanges :

- $MeOOC-A_{MG}-CONMe_2$
- $MeOOC-A_{ES}-CONMe_2$
- $PeOOC-A_{MG}-CONMe_2$
- $PeOOC-A_{ES}-CONMe_2$

- CycloOOC-$A_{MG}$-$CONMe_2$,
- CycloOOC-$A_{ES}$-$CONMe_2$
- EhOOC-$A_{MG}$-$CONMe_2$
- EhOOC-$A_{ES}$-$CONMe_2$
- PeOOC-$A_{MG}$-$CONEt_2$
- PeOOC-$A_{ES}$-$CONEt_2$
- CycloOOC-$A_{MG}$-$CONEt_2$
- CycloOC-$A_{ES}$-$CONEt_2$
- BuOOC-$A_{MG}$-$CONEt_2$
- BuOOC-$A_{ES}$-$CONEt_2$,
- BuOOC-$A_{MG}$-$CONMe_2$,
- BuOOC-$A_{ES}$-$CONMe_2$,
- EtBuOOC-$A_{MG}$-$CONMe_2$,
- EtBuOOC-$A_{ES}$-$CONMe_2$,
- nHE-OOC-$A_{MG}$-$CONMe_2$,
- nHE-OOC-$A_{ES}$-$CONMe_2$,

où :

- Me représente un groupe méthyle
- $A_{MG}$ représente un groupe $MG_a$ de formule $-CH(CH_3)-CH_2-CH_2-$ ; ou un groupe $MG_b$ de formule $-CH_2-CH_2-CH(CH_3)-$ ; ou un mélange des groupes $MG_a$ et $MG_b$ précités
- $A_{ES}$ représente un groupe $ES_a$ de formule $-CH(C_2H_5)-CH_2-$ ; ou un groupe $ES_b$ de formule $-CH_2-CH(C_2H_5)-$ ; ou un mélange de groupes $ES_a$ et $ES_b$
- Pe représente un groupe pentyle, de préférence isopentyle ou isoamyle,
- Cyclo représente un groupe cyclohexyle
- Eh représente un groupe 2-éthylhexyle,
- Bu représente un groupe butyle, de préférence n-butyle ou tertiobutyle,
- Et représente un groupe éthyle et EtBu représente un groupe éthylbultyle,
- nHE représente un groupe n-hexyle.

Selon un mode de réalisation avantageux le composé de formule (I) utilisé selon l'invention a un point de fusion inférieur à ou égal à 20°C, de préférence à 5°C, de préférence à 0°C.

Les composés de formule (I) utiles selon l'invention peuvent être préparés par toute méthode connue en soi. On peut notamment mettre en oeuvre une étape de réaction d'un anhydride répondant à la formule (I') ci-dessous, avec un alcool de formule $R^1$-OH et/ou une amine de formule $HNR^2R^3$

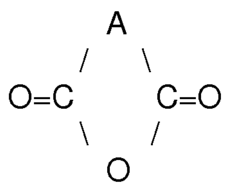 (I').

L'anhydride peut être préparé lors d'une étape préalable a) de cyclisation d'un diacide de formule HOOC-A-COOH, de préférence par réaction du diacide avec de l'anhydride acétique. On peut notamment opérer un reflux dans un excès d'anhydride acétique. Ensuite on peut opérer une condensation du produit de formule (I').

On peut notamment mettre en oeuvre l'une des séquences réactionnelles 1) ou 2) suivantes:

Séquence 1):

Etape 1b) on fait réagir l'anhydride de formule (I') avec un alcool de formule $R^1$-OH, de manière à obtenir un composé ester-acide de formule (I") $R^1$-OOC-A-COOH,

Etape 1c) on transforme le composé de formule (I") en composé de formule (I) à l'aide d'une amine de formule $HNR^2R^3$,

Séquence 2):

Etape 2b) on fait réagir l'anhydride de formule (I') avec une amine de formule $HNR^2R^3$ de manière à obtenir un composé amide-acide de formule (II")

HOOC-A-CONR$^2$R$^3$ (II'),

Etape 2c) on transforme le composé de formule (II") en composé de formule (I) à l'aide d'un alcool de formule $R^1$-OH.

L'étape 1b) est de préférence mise en oeuvre à l'aide d'au moins 1 équivalent molaire d'alcool, par rapport à l'anhydride. On peut mettre en oeuvre un fort excès d'alcool, par exemple de 2 à 20 équivalents, notamment de 5 à 15. On peut notamment utiliser l'alcool comme solvant de la réaction.

Selon un mode de réalisation particulier l'étape 1c) comprend les étapes suivantes (qui peuvent être simultanées ou subséquentes, de préférence subséquentes):

1c1) on transforme le composé de formule (I") en un chlorure d'acyle de formule (I'") suivante, de préférence par réaction avec du chlorure de thionyle,

$R^1$-OOC-A-COCl (I'")

1c2) on fait réagir le composé de formule (I'") avec l'amine de formule $HNR^3R^4$ de manière à obtenir le composé de formule (I).

L'étape 1c2) s'accompagne de formation d'acide chlorhydrique. On peut utiliser un base afin de le piéger, par exemple de la triéthanolamine ou triéthylamine (TEA). Cette étape peut être mise en oeuvre avec au moins 0,8 équivalent molaire d'amine, de préférence avec au moins un équivalent. On peut notamment mettre en oeuvre un excès de 1,05 à 1,4 équivalents molaires.

Selon un autre procédé utile pour préparer le composé de l'invention, on met en oeuvre une étape de réaction d'un diester de formule $R^1$OOC-A-COOR$^1$ avec une amine de formule $HNR^2R^3$, puis éventuellement une étape de réaction avec un alcool de formule $R^{1'}$-OH, où $R^{1'}$ est un groupe choisi parmi les groupes $R^1$ mentionnés plus haut, mais différent du groupe $R^1$ du diester. Ce procédé est particulièrement intéressant et économique car les diesters sont préparés en grandes quantités et facilement disponibles. Il est ainsi possible d'optimiser les processus de production. On peut par exemple mettre en oeuvre la séquence réactionnelle 3) suivante:
Séquence 3)

Etape 3a) on fait réagir un diester de formule $R^1$OOC-A-COOR$^1$, de préférence de formule MeOOC-$A_{MG}$-COOMe

ou $MeOOC\text{-}A_{ES}\text{-}COOMe$ avec une amine de formule $HNR^2R^3$ de manière à obtenir un produit comprenant un esteramide de formule:

$$R^1OOC\text{-}A\text{-}CONR^2R^3,$$

de préférence $R^1OOC\text{-}A_{MG}\text{-}CONR^2R^3$ ou $R^1OOC\text{-}A_{ES}\text{-}CONR^2R^3$, de préférence $MeOOC\text{-}A_{MG}\text{-}CONR^2R^3$ ou $MeOOC\text{-}A_{ES}\text{-}CONR^2R^3$

Etape 3b) éventuellement, on fait réagir avec un alcool de formule $R^{1'}\text{-}OH$ de manière à obtenir un produit comprenant un esteramide de formule

$$R^{1'}OOC\text{-}A\text{-}CONR^2R^3$$

de préférence $R^{1'}OOC\text{-}A_{MG}\text{-}CONR^2R^3$ ou $R^{1'}OOC\text{-}A_{ES}\text{-}CONR^2R^3$.

où $R^{1'}$ est un groupe choisi parmi les groupes $R^1$ mentionnés plus hauts, mais différent du groupe $R^1$ du diester.

Si le diester de départ présente le groupe $R^1$ du composé souhaité, alors l'étape 3b) est généralement inutile. Sinon on mettra typiquement en oeuvre cette étape. De préférence on part du diester présentant le groupe $R^1$ souhaité.

Lors de l'étape 3a) on met de préférence en oeuvre de 0,7 à 1,5, par exemple 0,8 à 1,2 moles, de préférence de 0,9 à 1,1 moles, de préférence environ 1 mole, d'amine par mole de diester. Il est avantageux d'opérer avec un léger excès comme un excès d'au moins 1,05 mole d'amine par mole de diester, par exemple de 1,05 à 1,1 mole d'amine par mole de diester.

L'étape 3a) peut être mise en oeuvre en solution, par exemple en solution aqueuse, ou en solution dans un solvant comme du toluène ou un alcool. On préfère opérer dans en solution non aqueuse, en évitant toute présence d'eau. On peut au cours de cette étape éliminer progressivement le méthanol formé afin de favoriser la réaction. L'élimination peut s'accompagner d'une élimination du solvant, par exemple à un azéotrope. Après séparation du méthanol le solvant éliminé peut être réintroduit dans le procédé. L'étape 3a) est de préférence mise en oeuvre en présence d'un catalyseur, en particulier d'un catalyseur de type basique. On peut par exemple utiliser des méthylates comme MeONa, des carbonates comme $K_2CO_3$, $Na_2CO_3$, des titanates.

L'étape 3b) est une étape de trans-esterification. Elle peut notamment être catalysée par des acides ou des bases, par exemple par $K_2CO_3$, ou $Na_2CO_3$

On note que dans tous les procédés et séquences mentionnés ci-dessus, on peut mettre en oeuvre des étapes optionnelles intermédiaires de séparation et/ou de purification, afin d'éliminer des sous-produits non visés. Les sous-produits peuvent être éventuellement utilisés pour fabriquer d'autres produits, ou peuvent être transformés afin d'être re-introduits dans le procédé.

La réaction peut être suivie d'étapes de filtration et/ou de purification par exemple par distillation.

Les diacides, le cas échéant sous forme de mélanges, peuvent notamment être obtenus à partir d'un mélange de composés dinitriles, le cas échéant sous forme de mélanges. Les dinitriles peuvent notamment être des dinitriles produits et récupérés dans le procédé de fabrication de l'adiponitrile par double hydrocyanation du butadiène. Dans ce cas il peut s'agir de mélanges de dinitriles. Ce procédé utilisé à grande échelle dans l'industrie pour produire la grande majorité de l'adiponitrile consommé dans le monde est décrit dans de nombreux brevets et ouvrages.

La réaction d'hydrocyanation du butadiène conduit majoritairement à la formation de dinitriles linéaires mais également à une formation de dinitriles ramifiés dont les deux principaux sont le méthylglutaronitrile et l'éthylsuccinonitrile.

Dans les étapes de séparation et de purification de l'adiponitrile, les composés dinitriles ramifiés sont séparés par distillation et récupérés, par exemple, comme fraction de tête dans une colonne de distillation.

Des diacides utiles peuvent être obtenus par réaction entre les composés dinitriles et une base minérale, pour obtenir des sels d'acide, puis neutralisation de ces sels par un acide. Des diacides utiles peuvent également être obtenus par hydrolyse acide des composés dinitriles.

Des diesters de formule $R^1OOC\text{-}A\text{-}COOR^1$ utiles pour la mise en oeuvre de la séquence 3 sont disponible dans le commerce, notamment auprès de la société Invista sous les références DBE, ou auprès de la société Solvay sous le nom Rhodiasolv® RPDE.

Des procédés de préparation de diacides et/ou de diesters sont notamment décrits dans les documents WO2007/101929, FR 2902095, WO 2008/009792, WO 2008/062058.

### *Les solvants (S2) et (S3)*

Il n'y a pas, dans l'absolu, de limitation quant à la nature exacte du DMSO et de la cyclopentanone employées selon l'invention.

Néanmoins, il peut être intéressant d'employer des mélanges comprenant à titre de solvant (S2) du DMSO

sous forme purifiée, présentant une odeur moins forte. On peut par exemple employer du DMSO obtenu selon le procédé décrit dans le brevet US 8,076,519.

Un exemple de mise en oeuvre de l'invention est donné ci-après à titre illustratif :

## *EXEMPLE*

On a testé un mélange selon l'invention comprenant :

- 50% en masse de **Rhodiasolv Polarclean ®**
  (Solvant de type (S1) - produit commercial tel que disponible auprès de la société Solvay)
  et
- 50% en masse de **DMSO Evol ®**
  (Solvant de type (S2) - produit commercial tel que disponible auprès de la société Arkema)

Le mélange s'avère efficace pour décaper sélectivement un film de résine photosensible après irradiation sélective d'une partie seulement de sa surface et laisser sur la surface uniquement les parties insolubles du film.

## Revendications

**1.** Utilisation, pour le décapage d'une résine photosensible, d'un mélange de solvants comprenant au moins deux des solvants (S1), (S2) et (S3) ci-après :

(S1) un solvant comprenant au moins un composé esteramide répondant à formule (I) suivante :

$$R^1OOC\text{-}A\text{-}CONR^2R^3 \qquad (I)$$

où:

$R^1$ est un groupe choisi parmi les groupes hydrocarbonés comprenant un nombre moyen d'atomes de carbone allant de 1 à 36, saturés ou insaturés, linéaires ou ramifiés, éventuellement cycliques, éventuellement aromatiques,
$R^2$ et $R^3$, identiques ou différents, sont des groupes choisis parmi les groupes hydrocarbonés comprenant un nombre moyen d'atome de carbone allant de 1 à 36, saturés ou insaturés, linéaires ou ramifiés, éventuellement cycliques, éventuellement aromatiques, éventuellement substitués, $R^2$ et $R^3$ pouvant éventuellement former ensemble un cycle, éventuellement substitué et/ou comprenant éventuellement un hétéroatome, et
A est un groupe alkyle divalent linéaire ou ramifié comprenant un nombre moyen d'atomes de carbone allant de 2 à 12, de préférence de 2 à 4.

(S2) le diméthylsulfoxyde DMSO
(S3) la cyclopentanone $C_5H_8O$.

**2.** Utilisation selon la revendication 1, où le mélange de solvants comprend ou consiste en un mélange du solvant (S1) et du solvant (S2).

**3.** Utilisation selon la revendication 2, où le rapport massique S1/S2 de la masse du solvant (S1) rapportée à la masse du solvant (S2) est supérieur ou égal à 1.

**4.** Utilisation selon la revendication 2, où le rapport massique S1/S2 de la masse du solvant (S1) rapportée à la masse du solvant (S2) est inférieur ou égal à 1.

**5.** Utilisation selon la revendication 1, où le mélange de solvants comprend ou consiste en un mélange du solvant (S1) et du solvant (S3).

**6.** Utilisation selon la revendication 5, où le rapport massique S1/S3 de la masse du solvant (S1) rapportée à la masse du solvant (S3) est compris entre 1 et 20.

**7.** Utilisation selon la revendication 1, où le mélange de solvants comprend ou consiste en un mélange du solvant (S2) et du solvant (S3).

**8.** Utilisation selon la revendication 1, où le mélange de solvants comprend ou consiste en un mélange du solvant (S1), du solvant (S2) et du solvant (S3).

**9.** Utilisation selon l'une des revendications 1 à 8, où le rapport massique S3/(S1+S2) est inférieur à 10%, par exemple entre 2 et 7%.

**10.** Procédé de dépôt sélectif d'un revêtement sur certaines zones seulement de la surface d'un substrat, comprenant :

(a) un dépôt sur ladite surface d'un film de résine photosensible ; puis
(b) une irradiation sélective dudit film sur certaines zones uniquement ; puis
(c) le décapage dudit film par un solvant de décapage ,
où ledit solvant de décapage est un mélange de solvants tel que défini dans l'une quelconque des revendications 1 à 9.

**Patentansprüche**

**1.** Verwendung einer Mischung von Lösungsmitteln, die mindestens zwei der nachstehenden Lösungsmittel (S1), (S2) und (S3) umfasst, zum Strippen eines lichtempfindlichen Harzes:

(S1) ein Lösungsmittel, das mindestens eine Esteramid-Verbindung der folgenden Formel (I) umfasst:

$$R^1OOC\text{-}A\text{-}CONR^2R^3 \qquad (I),$$

wobei:

$R^1$ für eine Gruppe steht, die aus gesättigten oder ungesättigten, linearen oder verzweigten, gegebenenfalls cyclischen, gegebenenfalls aromatischen Kohlenwasserstoffgruppen mit einer durchschnittlichen Zahl von Kohlenstoffatomen im Bereich von 1 bis 36 ausgewählt ist,
$R^2$ und $R^3$ gleich oder verschieden sind und für Gruppen stehen, die aus gesättigten oder ungesättigten, linearen oder verzweigten, gegebenenfalls cyclischen, gegebenenfalls aromatischen, gegebenenfalls substituierten Kohlenwasserstoffgruppen mit einer durchschnittlichen Zahl von Kohlenstoffatomen im Bereich von 1 bis 36 ausgewählt sind, wobei $R^2$ und $R^3$ gegebenenfalls zusammen einen Ring, der gegebenenfalls substituiert ist und/oder gegebenenfalls ein Heteroatom umfasst, bilden können, und
A für eine lineare oder verzweigte zweiwertige Alkylgruppe mit einer durchschnittlichen Zahl von Kohlenstoffatomen im Bereich von 2 bis 12, vorzugsweise von 2 bis 4, steht,

(S2) Dimethylsulfoxid DMSO,
(S3) Cyclopentanon $C_5H_8O$.

**2.** Verwendung nach Anspruch 1, wobei die Mischung von Lösungsmitteln eine Mischung von Lösungsmitteln (S1) und Lösungsmittel (S2) umfasst oder daraus besteht.

**3.** Verwendung nach Anspruch 2, wobei das Massenverhältnis S1/S2 der Masse des Lösungsmittels (S1) zur Masse des Lösungsmittels (S2) größer oder gleich 1 ist.

**4.** Verwendung nach Anspruch 2, wobei das Massenverhältnis S1/S2 der Masse des Lösungsmittels (S1) zur Masse des Lösungsmittels (S2) kleiner oder gleich 1 ist.

**5.** Verwendung nach Anspruch 1, wobei die Mischung von Lösungsmitteln eine Mischung von Lösungsmittel (S1) und Lösungsmittel (S3) umfasst oder daraus besteht.

**6.** Verwendung nach Anspruch 5, wobei das Massenverhältnis S1/S3 der Masse des Lösungsmittels (S1) zur Masse des Lösungsmittels (S3) zwischen 1 und 20 liegt.

**7.** Verwendung nach Anspruch 1, wobei die Mischung von Lösungsmitteln eine Mischung von Lösungsmittel (S2) und Lösungsmittel (S3) umfasst oder daraus besteht.

**8.** Verwendung nach Anspruch 1, wobei die Mischung von Lösungsmitteln eine Mischung von Lösungsmittel (S1), Lösungsmittel (S2) und Lösungsmittel (S3) umfasst oder daraus besteht.

**9.** Verwendung nach einem der Ansprüche 1 bis 8, wobei das Massenverhältnis S3/(S1+S2) kleiner als 10 % ist und beispielsweise zwischen 2 und 7 % liegt.

**10.** Verfahren zur selektiven Abscheidung einer Beschichtung nur auf bestimmten Zonen der Oberfläche eines Substrats, das Folgendes umfasst:

(a) Abscheiden eines Films aus lichtempfindlichem Harz auf der Oberfläche; dann
(b) selektives Bestrahlen des Films nur auf bestimmten Zonen; dann
(c) Strippen des Films mit einem Stripplösungsmittel,
wobei es sich bei dem Stripplösungsmittel um eine Mischung von Lösungsmitteln gemäß einem der Ansprüche 1 bis 9 handelt.

## Claims

**1.** Use, for stripping a photoresist, of a mixture of solvents comprising at least two of the solvents (S1), (S2) and (S3) below:

(S1) a solvent comprising at least one esteramide compound corresponding to formula (I) below:

$$R^1OOC\text{-}A\text{-}CONR^2R^3 \qquad (I)$$

wherein:

$R^1$ is a group selected from saturated or unsaturated, linear or branched, optionally cyclic, optionally aromatic, hydrocarbon-based groups comprising an average number of carbon atoms ranging from 1 to 36,
$R^2$ and $R^3$, which may be identical or different, are groups selected from saturated or unsaturated, linear or branched, optionally cyclic, optionally aromatic, optionally substituted, hydrocarbon-based groups comprising an average number of carbon atoms ranging from 1 to 36, $R^2$ and $R^3$ together optionally being able to form a ring, which is optionally substituted and/or optionally comprises a heteroatom, and
A is a linear or branched divalent alkyl group comprising an average number of carbon atoms ranging from 2 to 12, preferably from 2 to 4

(S2) dimethyl sulfoxide DMSO
(S3) cyclopentanone $C_5H_8O$.

**2.** Use according to Claim 1, wherein the mixture of solvents comprises or consists of a mixture of the solvent (S1) and of the solvent (S2).

**3.** Use according to Claim 2, wherein the S1/S2 weight ratio of the weight of the solvent (S1) relative to the weight of the solvent (S2) is greater than or equal to 1.

**4.** Use according to Claim 2, wherein the S1/S2 weight ratio of the weight of the solvent (S1) relative to the weight of the solvent (S2) is less than or equal to 1.

**5.** Use according to Claim 1, wherein the mixture of solvents comprises or consists of a mixture of the solvent (S1) and of the solvent (S3).

**6.** Use according to Claim 5, wherein the S1/S3 weight ratio of the weight of the solvent (S1) relative to the weight of the solvent (S3) is between 1 and 20.

**7.** Use according to Claim 1, wherein the mixture of solvents comprises or consists of a mixture of the solvent (S2)

and of the solvent (S3).

**8.** Use according to Claim 1, wherein the mixture of solvents comprises or consists of a mixture of the solvent (S1), of the solvent (S2) and of the solvent (S3) .

**9.** Use according to one of Claims 1 to 8, wherein the S3/(S1+S2) weight ratio is less than 10%, for example between 2% and 7%.

**10.** Process for selective depositing of a coating on certain zones only of the surface of a substrate, comprising:

(a) depositing of a film of photoresist on said surface; then
(b) selective irradiation of said film on certain zones only; then
(c) stripping of said film with a stripping solvent,
wherein said stripping solvent is a mixture of solvents as defined in any one of Claims 1 to 9.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- WO 2007101929 A
- FR 2902095
- WO 2008009792 A
- WO 2008062058 A
- US 8076519 B